# EUROPEAN PATENT APPLICATION

(11) **EP 4 654 805 A1**
(43) Date of publication of application: **26.11.2025**
(21) Application number: 24177655.8
(22) Date of filing: 23.05.2024
(51) Int. Cl.: H10K 71/40, H10K 85/50, H10K 30/86, H10K 30/40

(54) **METHOD FOR PREPARATION OF PEROVSKITE LAYER FOR PEROVSKITE SOLAR CELLS AND PRELIMINARY LAYER FOR PEROVSKITE**

(71) Applicant: Helmholtz-Zentrum Berlin für Materialien und Energie GmbH, 14109 Berlin (DE)
(72) Inventor: Leyden, Matthew, 12559 Berlin (DE); Roß, Marcel, 12437 Berlin (DE); Skorjanc, Viktor, 12355 Berlin (DE); Miaskiewicz, Aleksandra, 10785 Berlin (DE); Severin, Stefanie, 12527 Berlin (DE); Albrecht, Steve, 14542 Werder (DE)

(57) **Abstract**

The invention concerns a method for preparation of perovskite layer for perovskite solar cells and a preliminary layer for building a perovskite. The inventive methods encompasses basically the steps of:
a. Providing a substrate;
b. Providing a first solution or gel encompassing a base material for the formation of a charge carrier layer as well as precursor molecules for organic cations in a perovskite;
c. Coating the substrate with the first solution for the formation of a preliminary layer composed of the molecules for forming a charge carrier layer together with the precursor molecules for organic cations in a perovskite;
d. Providing at least one more solution with precursor molecules for the formation of a perovskite;
e. Coating the at least one further solution directly on top of the preliminary layer via evaporation;
f. Annealing the coated substrate.

The inventive methods result in enhanced homogeneity in the formed perovskite and enables easy incorporation of organic cations into the perovskite while performing a low cost method.

The inventive preliminary layer for building a perovskite as involved in the inventive method encompass at least molecules for the formation of a charge carrier layer as well as precursor molecules for organic cations in a perovskite.

## Description

### Introduction

Organo-lead-halide perovskites, have shown great potential in optoelectronic application, most notably as a solar cell absorber material. These materials often have a high absorption coefficient, relatively high and balanced carrier mobility that have allowed them to demonstrate high photo conversion efficiency up to ~26.1%.1 This is comparable to the best single crystal solar cell (27.6%), and a few years ago exceeded the best multi crystalline silicon solar cells (23.3%). Perovskites are a family of materials of anything with an ABXs structure. However, most recent attention has been on lead or tin based halide perovskite. The highest performing perovskite solar cells typically use an organic cation like for example Formamidinium (FA) or methylammonium (MA).

Evaporation is a proven technology for industrial applications. One of the most relevant examples is in the application of CdTe, which is the dominant thin film solar technology. One of the most interesting applications for perovskites is its application to tandem solar cells, where perovskite materials can complement existing successful technologies like silicon. Perovskites have a tunable bandgap and can be optimized to be compatible with their substate and now have demonstrated impressive efficiencies of over 30% as a tandem solar cell. Silicon solar cells are often textured with pyramids that better help the cells capture light. However, if the pyramids are too large this often presents a challenge to solution processed perovskite films. Frequently, perovskite researchers resolve this by using smaller pyramids. Evaporated films are highly conformal, and should be able to be deposited on high aspect ratio pyramids.

Another advantage of evaporated perovskites is that they do not require the use of toxic solvents like DMF (Dimethylformamide) to dissolve precursors, or antisolvents like chlorobenzene. Large amounts of lead containing toxic solvents may become a problem when scaling up production.

Lastly, evaporated perovskites can be patterned by shadow masking, which potentially skips post patterning steps that may be required for solution processed films such laser ablation.

Evaporation of perovskite materials has a long history. Despite this long history of research, evaporation materials had lagged behind solution-based cells until recently. Now sequential based evaporation techniques appear to have caught up and now are largely on par with the best solution processed.

Perovskite solar cells, as well as other solar, are commonly made with charge transport layers forming an PIN, or NIP structure. Where N, P, and I signify negative, positive, and intrinsic transport. The perovskite is typically the intrinsic material situated between the N and P contact layers (front or back). Self-assembled monolayers (SAM) have been introduced for application to evaporated perovskite films as hole transporting layers with promising results. For example, the molecule (2-(3,6-Dimethoxy-9H-carbazol-9-yl)ethyl)phosphonic acid (Meo2Pacz) forms a self-assembled monolayer, where the phosphonic acid tail binds to hydroxyl groups present on the surface of transparent conducting oxide. Recently the family of carbazole SAM molecules has gained popularity as a robust method to forming a hole transport layer for perovskite optoelectonics.

### Problem

For all the advantages perovskite evaporation is not without its challenges. Typically, evaporation systems have a significantly higher capital equipment cost than spin coating, which could deter researchers or companies who may wish to operate at small scales. It is difficult to incorporate new materials into an equipped evaporation, as it will typically require a new source in the chamber. Furthermore, many of the materials that may aid in the function of perovskite solar cells may not evaporate easily (e.g, too volatile, or non-directional), making the process difficult to control. Perovskite evaporation is also currently one or two orders of magnitude slower than spin coating. The combination of high capital equipment costs and low throughput effectively makes the product more expensive. For co-deposition it can be challenging to incorporate a low fractional rate, for example low-D cation may be beneficial to resultant perovskite, but only at concentrations that one or two orders of magnitude lower than other cations. Incorporating these small fractions by co-evaporation may be challenging.

### Solution

The invention concerns in a first aspect a method of preparation of perovskite layers for perovskite solar cells. The inventive idea is to have in the method of preparation of perovskite layers for perovskite solar cells a layer which is prepared before the preparation of the perovskite. The perovskite is prepared directly on top of this layer. This layer is encompassing base material for forming a charge carrier layer together with precursor molecules for cations in a perovskite. The precursor molecules for cations in a perovskite are incorporated into the perovskite layer when the perovskite layer is evaporated on top of the preliminary layer and annealed. The precursor molecules in the layer diffuse into the perovskite layer during annealing. After the precursor molecules have gone, the base material for forming a charge carrier layer is left and this base material is forming there upon a charge carrier layer. Following this, the layer encompassing base material for forming a charge carrier layer together with precursor molecules for organic cations in a perovskite is a preliminary layer. It is addressed in the following by using this notation.

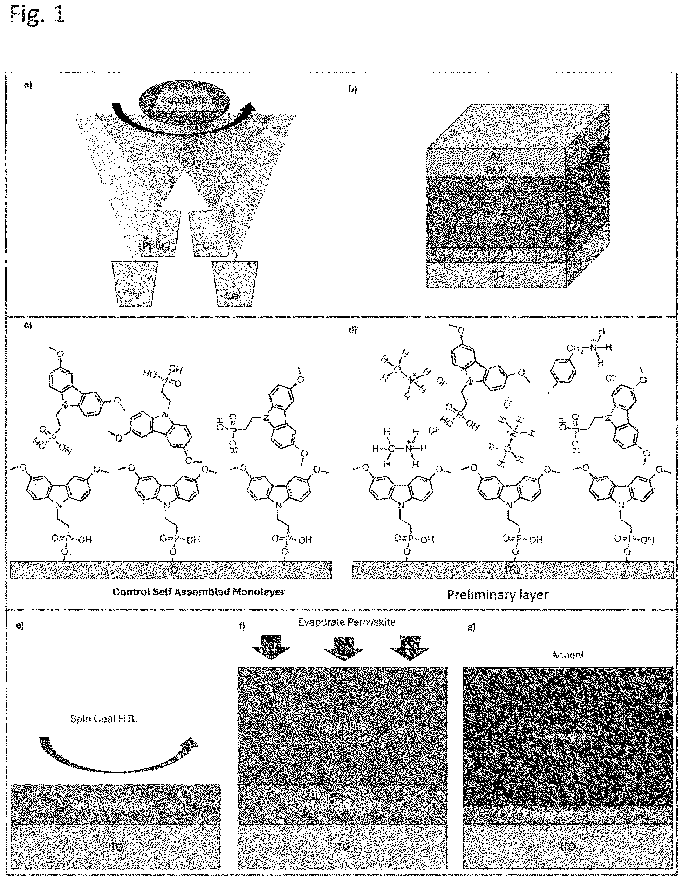

The approach of a preliminary layer composed from base material for forming a charge carrier layer together with precursor molecules for cations in a perovskite alleviates some of the challenges facing perovskite evaporation. The concept is illustrated in figure 1, by the example of SAM-molecules as base material for forming the charge carrier layer encompassed in the preliminary layer. Precursor molecules for cations in a perovskite are coated together with the base material (here as example the SAM-molecules), by adding them into the for-example solutions, gels, powder sources and the like used for the coating of the preliminary layer. In the example in fig. 1 it is a solution. The precursor molecules are incorporated into the resultant preliminary layer which also encompass the base material for building a charge carrier layer. Still a functional charge carrier layer will be formed in further proceeding the method for preparation of a perovskite. The precursor molecules in the preliminary layer result in becoming part of the crystal structure of a perovskite evaporated on top of the preliminary layer whereafter a charge carrier layer remains beneath the perovskite layer. This requires advantageously no additional processing step. The precursor molecules encompass particularly those which are otherwise not desirable to deposit via evaporation together with the to be applied perovskite and especially encompass precursor molecules for organic cations of a to be formed perovskite. Different precursor molecules may be loaded into the preliminary layer at the same time. In the subsequent steps in the method, which is the step where the perovskite layer is coated directly on top of the preliminary layer via evaporation and is subsequently annealed, the precursor molecules within the preliminary layer became mobilized and are incorporated into the perovskite layer via diffusion. What remains is a charge carrier layer, composed of the base material for forming it. Incorporating in the inventive preliminary layer precursor molecules which are volatile, and which would otherwise only hardly to become incorporated in the perovskite via evaporation, the resulting perovskite achieved is of enhanced quality with respect to crystallinity and homogeneity and furthermore the efficiency of a finalized perovskite solar cell under usage of an inventive preliminary layer is enhanced.

The invention concerns in just another aspect a preliminary layer which is encompassing base material for forming a charge carrier layer together with precursor molecules for cations in a perovskite, especially with precursor molecules for organic cations in a perovskite.

In one embodiment of the invention the base material for forming a charge carrier layer is made by SAM-molecules and in yet another embodiment the base material for forming the charge carrier layer is made by SAM-molecules forming a hole transporting layer.

The precursor molecules in the sense of the invention must be co-soluble or else to be co-coated together with the base material for forming the charge carrier layer. A solution or gel or the like which encompass both the precursor molecules and the base material is provided. The precursor molecules need to be precursors for an organic cation in the to be formed perovskite.

The precursor molecules for cations in a perovskite can be potentially at least one type of the following list
specific to metal halide perovskites:
Methylammonium halide (CH6IN),
Formamidinium halide (CH5IN, FA),
Cesium Halide, Potassium halide,
Rubidium halide,
Acetamidinium halide (C2H7IN2),
4-Aminoethylpyridine halide,
3 Aaminomethylpiperidinium halide,
5-Azaspiro [4.4] nonan-5-ium halide (C8H16IN),
1,4-benzenedimethanamonium halide,
1,4·Benzyliammonium halide (C6H10I2N2),
Benzylammonium halide (C7H10IN),
1.4-butanediammonium halide,
iso Butylammonium halide (C4H11IN),
n-Butylammonium halide (C4H11IN),
t Butytammonium halide (C4H12IN),
Cyclohexylammonium halide (C6H14IN),
1,4 Diazabicyclo [2,2,2] octane-1,4-diium halide (C6H14I2N2),
Diethylammonium halide (C4H12IN),
Dimethylammonium halide (C2H12IN),
Ethane-1,2-diammonium halide (C2H10I2N2),
Ethylammonium halide (C2H8IN),
4-Fluoro-Benzylammonium halide (FC6H4SO2Cl, FBACl),
4-fluoro-phenethylammonium halide,
Guanidinium halide CH6IN3,
n Hexylammonium halide (C6H1IN),
Imidazolium halide (C3H5IN2),
n-Octylammonium halide (C8H20IN),
Phenethylammonium halide (C8H12IN),
Phenylammonium halide (C6H8IN),
Propane-1,3-diammonium halide (C3H12I2N2),
1,3-propanediamine halide,
2 propenammonium halide,
iso-Propylammonium halide (C3H10IN),
n-Propylammonium halide (C3H10IN),
Pyrrolidinium halide (C4H10IN),
Quinuclidin- 1-ium halide (C7H14IN),
2 thiophene-methylammonium halide,
2,5 thiophenedimehtylammonium halide,
2-thiopheneformamidinium halide.

The base materials for forming a charge carrier layer used will depend on the polarity of the charge carrier layer intended. For electron transporting layers, the following base materials are exemplarily:
Tin oxide nanoparticles,
Titanium oxide nanoparticles,
C60,
PC60BM

For hole transporting layers, the following base materials are exemplarily:
PEDOT:PSS,
Spiro,
Spiro-OMeTAD
Nickel oxide nanoparticles,
NiOₓ,
SnO₂
SAM.

The term SAM includes molecules with at least one type of molecule of formula (I) from the following: 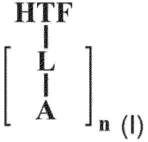
where L is a linking fragment, A an anchor group and HTF is a hole transporting fragment being selected from any of formula II or III,
a polycycle

   Z-D-Z (II),
wherein Z and D are homocyclic or at least one of Z or D includes a heteroatom selected from the group of N, S, O, Si and Z is a Cs or C₆ substituted or not substituted aromatic group, D is N or a Cs or C₆ aromatic group, wherein two carbon atoms of aromatic group D are each bonded to one of the two aromatic groups Z to form a tricycloundecane, a tricyclotridecane or a tricyclotetradecane derivative; or 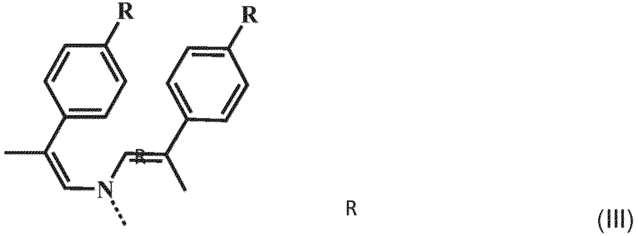
and R is a substituent.

The compound according to the invention functions as a hole transport material due to the electron localization. Therefore, connections that enable electron localization across the entire system are essentially preferred. In particular, delocalization between the Z fragments via fragment D. For this purpose, D prefers an aromatic fragment and/or an element with an electron-pushing character, which is in conjunction to the fragments Z. Particularly preferred, are symmetrical structures, i.e. connections that can be mirrored along an axis. Mirroring refers to the schematic structure and not necessarily to the actual steric appearance.

It is advantageous that the mirror axis runs through component D, so that the two Z components are equal or inverse.

For the formation of a SAM, the molecule of formula (I) can be mixed with other molecules, referred to as "filler molecules" FM. The FM is generally a molecule or a mixture of molecules consisting of an anchoring group (e.g. phosphonic acid, phosphoric acid, sulfuric acid, sulfonic acid, carboxylic acid, siloxanes), which can bind to the surface of the TCO, an alkyl chain of N carbon atoms, where N = 1-18, and a methyl, halogen, amino, bromide, ammonium and/or sulfuric functional group. Examples are ethyl- or butylphosphonic acid ("C2" or "C4"), or (Aminomethyl)phosphonic acid. The FM functions as a passivation agent, reducing charge carrier recombination between the TCO and perovskite, as well as an agent for modification of the wettability of the TCO. A preparation without FMs is always possible and with properly selected parts of HTF, L and A comes without detriment.

The ratio of HTM in the mixture is given by x in the range of 0.02 to 1. The ratio of the filler molecule FM is given by y = (1-x). For the HTM of formula (I) n is preferably equal to 1 or 2.

In preferred embodiments of the invention D is a C₅- or C₆-heteroaromatic group, wherein the heteroatom is N, Si, S and/or O.

In further preferred embodiments the hole transport fragment HTF is selected from any one of formula IV to XIX 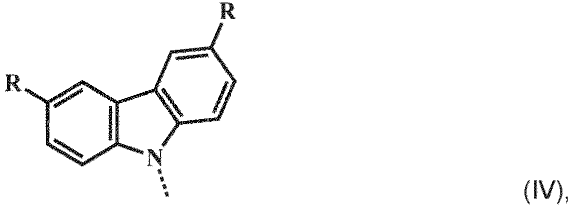 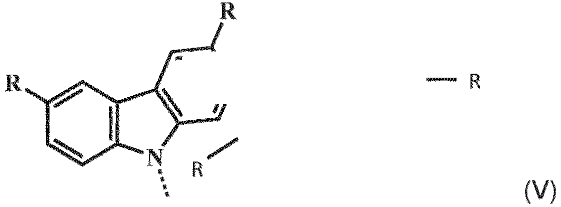 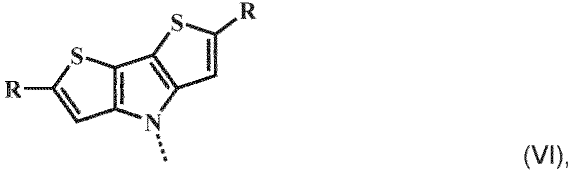 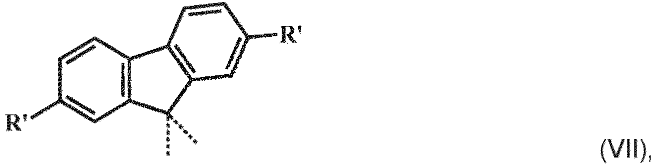 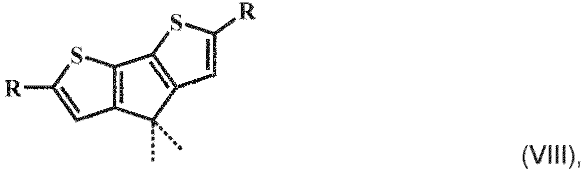 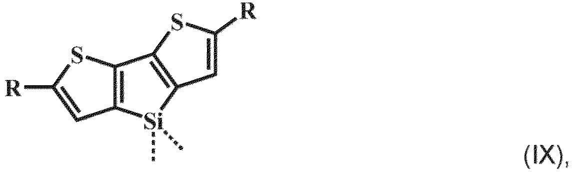 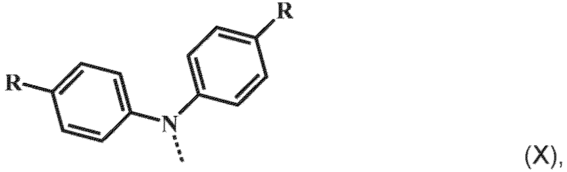 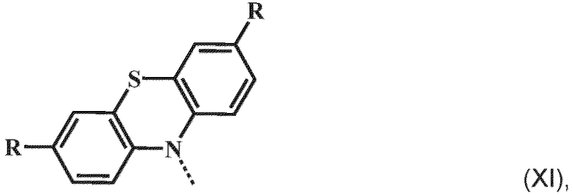 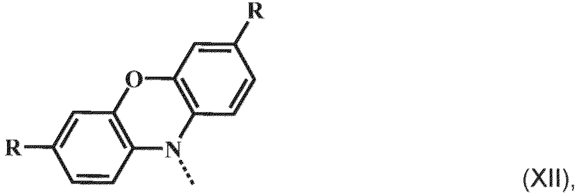 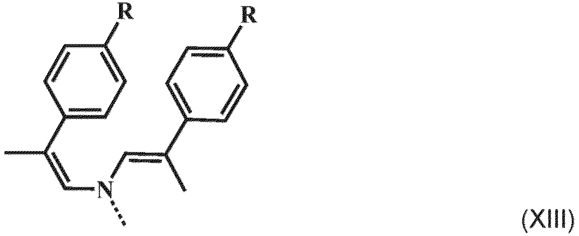 or

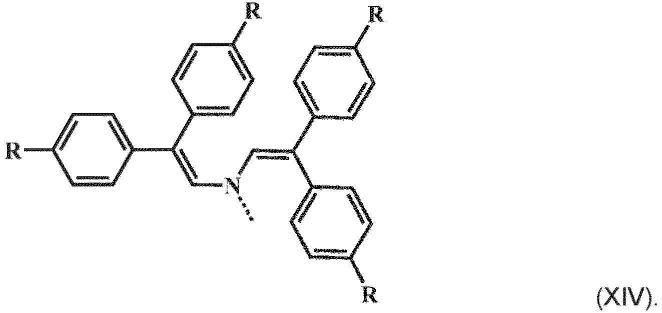

Alternatively or additionally, groups R are independently selected from the group consisting of H; C₁-C₁₀ alkyl; C₂-C₁₀ alkenyl; C₃-C₂₀ cycloalkyl; C₃-C₈ heterocycloalkyl, alkoxy, aryloxy, alkylthio, arylthio, amino, amido, ester, carboxylic acid, dialkoxy-diphenylamine, carbamate, urea, ketone, aldehyde, cyano, nitro, halogen; (cycloalkyl)alkyl and (heterocycloalkyl)alkyl.

In particular groups R are independently selected from Hydrogen 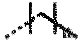 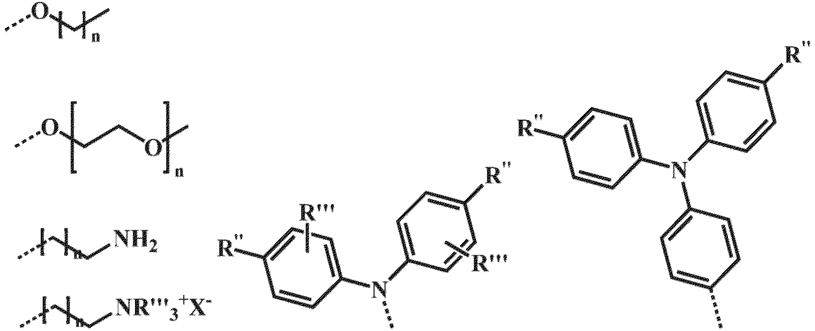 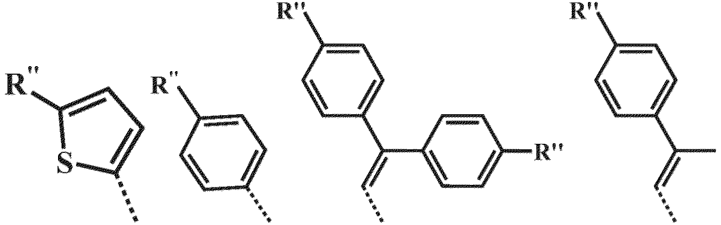 wherein
the dotted lines represent the bond by which R is connected to HTF according to formula II or III, X represents halogen (F, Cl, Br, I); R‴ represents hydrogen, alkyl (C₁-C₁₂) and/or R" represents hydrogen, alkyl, alkoxy (-CH₃; -OCH₃).

In further embodiments the linking fragement L is any one selected from C₁-C₉ alkylene, C₄-C₂₀ arylene, C₄-C₂₀ heteroarylene, C₄-C₂₀ alkylarylene, C₄-C₂₀ heteroalkylarylene heteroatoms being selected from O, N, S, Se, Si, wherein said alkylene, arylene, heteroarylene, alkylarylene, heteroalkylarylene, if they comprise three or more carbons, may be linear, branched or cyclic, especially selected from any one of 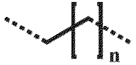 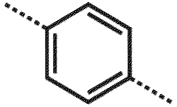 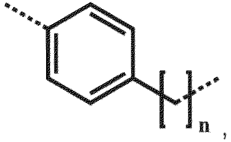 wherein
the dotted lines represent the bond by which L is connected to HTF according to formula II or III.

In preferred embodiments the anchor group A (head group) is any one selected from phosphonic acid, phosphoric acid, sulfuric acid, sulfonic acid, carboxylic acid, siloxanes, especially selected from any one of 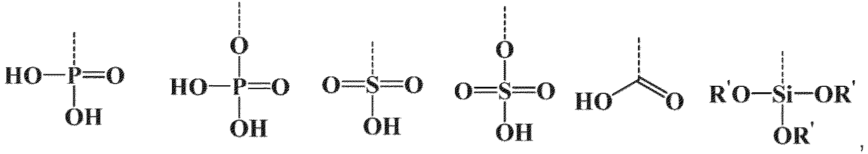 wherein
the dotted lines represent the bond by which A is connected to L according to one of the preceding claims and R' is preferably aliphatic.

Particularly the charge carrier layer is made up from SAM-molecules of the following list:
2-PACz - [2-(9H-Carbazol-9-yl)ethyl]phosphonic Acid,
Meo-2PACz - [2-(3,6-Dimethoxy-9H-carbazol-9-yl)ethyl]phosphonic Acid,
Meo-4PACz - [4-(3,6-Dimethyl-9H-carbazol-9-yl)butyl]phosphonic Acid.

Perovskites to be coated on top of the preliminary layer have the general formula ABXs, where A is a cation, B is typically a metal, and X is an anion. Additionally the term perovskite include Ruddlesden-Popper phase perovskites, which follow the following formula *Aₙ₋₁A'₂BₙX*_{*3n*+*1*}, where A' is a bulky cation. Possible precursor cations are listed above.

All other steps in a finalization of a perovskite solar cell as well as other appliances as for example LEDs, are unaffected by the inventive method and can be performed unchanged.

A substrate provided for a coating with loaded charge carrier layer encompasses at least a carrier (the substrate as such), for example a glass substrate, coated at least with an electrode, for example a transparent conductive oxide.

For the formation of a perovskite on top of the preliminary layer at least one further solution encompassing at least one precursor for building a perovskite is provided. The perovskite is coated via evaporation directly on top of the preliminary layer and annealed in a subsequent step. For the evaporation common systems are to be used.

During the evaporation of the perovskite and particularly within the annealing step the precursor molecules from the preliminary layer are mobilized and diffuse into the perovskite layer where it is incorporated in the perovskite structure. The charge carrier layer remains.

The solution encompassing the precursors for the perovskite, its evaporation as well as the annealing is all done after known procedures from the state of the art, well known by those skilled in the art.

The inventive method is an effective way to add precursor molecules for organic cations to evaporated perovskite films without additional processing steps, or additional sources in an evaporation chamber. This adds a great deal of flexibility to the choice of materials used, without any new complexity. The preliminary layer allow the formation of perovskite via evaporation with materials that may have only previously used by solution processing. Furthermore the crystallinity and homogeneity with respect to composition as well as reproducibility of the perovskite layer is enhanced.

### Examples

The invention is given in detail in two examples and two figures.
- Fig. 1:: Sketch of the inventive method (a, e, f, g), showing the inventive preliminary layer (d) and a finalized perovskite solar cell (b) as well as a normal charge carrier layer (c) for reference.

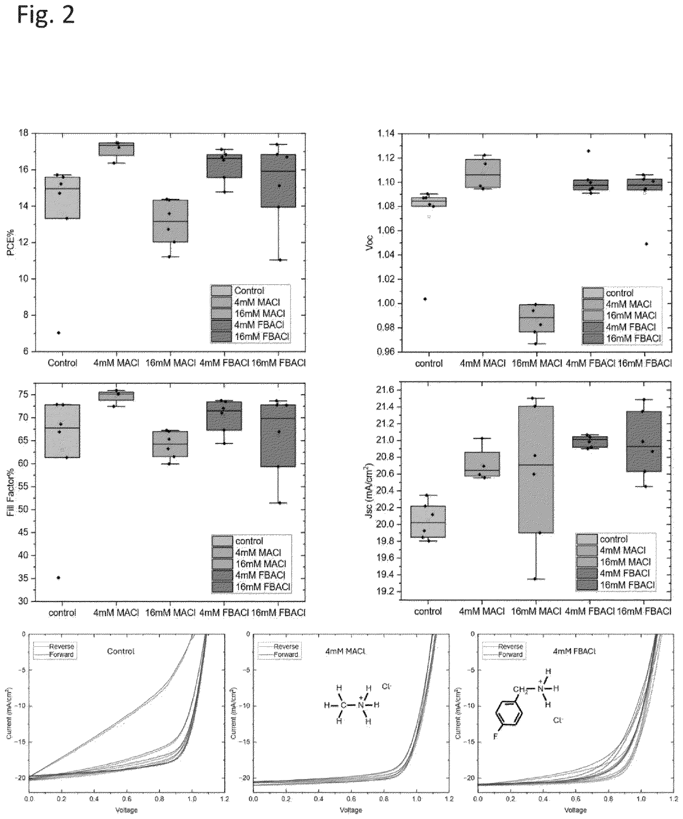

- Fig. 2:: Results from perovskite solar cells -stemming from different preliminary layers as substrate for the perovskite, all prepared during the same evaporation-performance test: a) Power conversion efficiency. b) Open circuit voltage. c) Fill factor. d) Short Circuit current. e) JV curves for the control substrate f) JV curves for the MACI treated substrate. g) JV curves for the FBACl treated substrate.

In one example the precursor molecules are methylammonium chloride (MACL), which is more volatile than other commonly used perovskite organic cations. In just another example 4-Fluoro-Benzylammonium chloride (FBACI) is taken as precursor molecules in a small quantity regarding the to be formed perovskite.

In the examples a 4-source co-evaporation system to deposit perovskite films is used, including lead halide, lead bromide, cesium halide, and formamidinium halide. With this approach it is possible to tune the bandgap of perovskite ranging from FAPbl3 (Formamidinium lead halide) to CsPbIBr₂ and potentially everything in between. Formamidinium (FA) and Cesium are generally considered to be more stable cation choices for perovskite.

The co-evaporation process for the formation of the perovskite in the example has nominal deposition rate of 0.6 A/s lead halide, 0.08 for lead bromine, 0.1 A/s cesium halide, and 0.6 A/s for formamidinium halide. The nominal rates based on tooling factor and may vary. The coating process is terminated at a film thickness ~330 nm of lead halide and ~60 nm of lead bromide. If we assume the density of lead halide, lead bromide and cesium halide are is 6.16 g/cm³, 6.66 g/cm³, and 4.51 g/cm³ we can make an estimate of the final ratio of the perovskite. The assumption is thereby that the ratios are mostly determined by the inorganics, and the FAI will absorb to full perovskite conversion. For this calculation the FAI rate is ignored because it is found that it is less consistent than the inorganic components. Given these assumptions, an estimate of the composition is FA0.74Cs0.26PbI2.7Br0.3, or approximately 10% bromine. We can also get a rough estimate of our expected thickness to be ~740 nm, if we assume the density of perovskite is like MAPbl3 (4.17 g/cm3).

The coating of a preliminary layer composed from SAM-molecules and the precursor molecules (see above), is done as follows. The solution is loaded with the precursor MACL in the same concentration as the example SAM-molecule Meo2Pacz (4 mM), plus at a higher concentration (16 mM). The thickness of the film of both concentrations is approximately the same at ~4nm. This can be explained by MACI being the smaller molecule than Meo2PACz. This may also explain why the film formation kinetics are not strongly changed, as the perovskite may still be able to directly interact with unbound Meo2PACz at the surface.

All solutions for forming a SAM as well as the preliminary layer used in the examples use a concentration of 4 mM Meo2PACz as the hole transporting material. The SAM-molecules are dissolved in a solution of isopropyl alcohol (IPA) with a concentration of 4 mM Meo2PACz. This solution includes a small amount of DMF (~30 ul/ml). The addition of DMF is reported to prevent the formation of micelles of the Meo2PACz, improves the solubility of precursors (e.g. MACI), and improves wetting and uniformity of the resultant film. The thickness of films was measured via ellipsometry to be between 4 to 7 nm.

In figure 1 a sketch of the inventive method is shown. The preliminary layer is composed of SAM-molecules and the precursor molecules. The precursor molecules that are co-coated with the SAM-molecules for building the preliminary layer improves the performance of the perovskite which is preparated upon the preliminary layer via evaporation. What is shown in detail is this: a) Diagram of a 4-source perovskite co-deposition. b) Full stack of the finalized perovskite solar cells used. c) Concept of an as spun film of a hole transport layer Meo-2PACz without additional precursor molecules. d) A preliminary layer composed of SAM-molecules together with the precursor molecules, whereof the latter are not used for the hole transport layer but are later incorporated into a perovskite film coated on top of the preliminary layer. e) Diagram of the deposition process of a preliminary layer, f) with a subsequently on top evaporated perovskite film. g) The perovskite film coated on top of the preliminary layer differ significantly from a -pristine- SAM after annealing, suggesting that the precursor molecules predominantly diffuses into the perovskite during annealing.

The annealing of the perovskite layer finalises the incorporation of the precursor molecules from the preliminary layer into the perovskite layer (g).

As shown in the figure as-spun films of SAM (c, d) are often not literally a monolayer. A monolayer is only formed if the solution concentration is quite low, or the subsequent film is rinsed. Solution based deposition techniques effectively wash off extra material, but that is not true for evaporated films. This extra material -as shown here schematically-, the precursor molecules, conditions the formation of the perovskite films. Adding a variety of precursor molecules at this stage takes advantage of the property of evaporated films.

In fig. 2 the performance of solar cells obtained by applying the inventive method, i.e. by having preliminary layers, prepared from solutions containing SAM-molecules together with the precursor molecules MACI and FBACI is depicted. a-d show box plots from the reverse scans of different preliminary layers processed, all prepared during the same evaporation. a) Power conversion efficiency. b) Open circuit voltage. Both MACI and FBA can improve the Voc of the solar cells but shows that at too high concentrations MACI can negatively impact Voc. c) Fill factor. MACI can improve the fill factor, but at higher concentrations both MACI and FBACI negatively impacted the performance of the solar cells. d) Short Circuit current. Both MACI and FBACI increase JSc for a wide range of concentrations. e) JV curves for the control substrate. f) JV curves for the MACI treated substrate. g) JV curves for the FBACl treated substrate. We see that FBACI seems to introduce hysteresis at this concentration.

The concentrations on precursor molecules may be tested to get the optimum amounts.

Additionally both precursor molecules were added at the same time to see if the effects add constructively. The concentration of FBACI were limited to 0.6 mM to reduce hysteresis. The results appear to be largely constructive, and the perovskite solar cells obtained via evaporation of perovskite onto preliminary layers have substantially increased Jsc, and some improvement in fill factor. There was not a significant improvement in the Voc compared to the control for this batch. This is slightly convoluted by the control (1.64 eV) having a larger bandgap than the those under usage of preliminary layers ~1.63 eV. The difference in bandgap could additionally explain some of the difference in Jsc. The net result is a substantial improvement in PCE, with peak performers going from ~17% to over 19% for the usage of preliminary layers films.

## Claims

1. Method for preparation of perovskite layers for perovskite solar cells encompassing at least the steps:
a. Providing a substrate;
b. Providing a first solution or gel encompassing a base material for the formation of a charge carrier layer as well as precursor molecules for organic cations in a perovskite;
c. Coating the substrate with the first solution for the formation of a preliminary layer composed of the molecules for forming a charge carrier layer together with the precursor molecules for organic cations in a perovskite;
d. Providing at least one more solution with precursor molecules for the formation of a perovskite;
e. Coating the at least one further solution directly on top of the preliminary layer via evaporation;
f. Annealing the coated substrate.

2. Method for preparation of perovskite layers for perovskite solar cells after claim 1,
**characterized in that**,
the charge carrier layer is formed by SAM molecules.

3. Method for preparation of perovskite layers for perovskite solar cells after claim 2,
**characterized in that**,
the charge carrier layer is formed by SAM molecules, composed of at least one kind of SAM-molecules from the following group: 2-PACz, Meo-2PACz, Meo-4PACz.

4. Preliminary layer for perovskite layers, encompassing at least molecules for the formation of a charge carrier layer as well as precursor molecules for organic cations in a perovskite.
